# EUROPEAN PATENT APPLICATION

(11) **EP 1 850 393 A2**
(43) Date of publication of application: **31.10.2007**
(21) Application number: 07008119.5
(22) Date of filing: 20.04.2007
(51) Int. Cl.: H01L 27/32

(54) **Display device and fabricating method thereof**

(30) Priority: 27.04.2006 KR 20060038118
(71) Applicant: Samsung Electronics Co., Ltd., Yeongtong-gu Suwon-city, Gyeonggi-do 442-742 (KR)
(72) Inventor: Jung, Kwang-chul, Gyeonggi-do (KR); Choi, Beohm-rock, Seoul (KR); Yoon, Young-soo, Gyeonggi-do (KR)
(74) Representative: Dr. Weitzel & Partner

(57) **Abstract**

A display device includes a substrate including a display region, and a reference voltage supplying unit disposed along at least one side of the display region which supplies a reference voltage to the display region, wherein the reference voltage supplying unit comprises; a first sub-supplying unit including a first voltage applying region which supplies the reference voltage to the display region, a first insulating layer disposed on the first sub-supplying unit, and a second sub-supplying unit disposed on the first insulating layer and including a second voltage applying region which supplies the reference voltage to the display region.

## Description

### BACKGROUND OF THE INVENTION

### Field of the Invention

The present invention relates to a display device and a fabricating method thereof.

### Description of the Related Art

Recently, organic light emitting diode ("OLED") devices have attracted attention and interest in the industry of flat panel display devices because of their low power consumption, light weight, slim shape, wide viewing angle, short response time, and other positive attributes.

The OLED display requires reference voltages such as a common voltage and a driving voltage. The common voltage and the driving voltage are supplied to a common electrode and a driving voltage line, respectively.

In one type of OLED display the reference voltages are supplied by a circuit board to the common electrode or the driving voltage line through a metal bar. In such a display, the circuit board is attached to one side of a substrate, and the metal bar is extended along a display region. Furthermore, the reference voltage is supplied through only one end of the extended metal bar.

One problem with this configuration is that one end of the metal bar to which the reference voltage is supplied generates a lot of heat due to its electrical resistance, and the reference voltage decreases as a function of distance from the circuit board.

### BRIEF SUMMARY OF THE INVENTION

Accordingly, it is an aspect of the present invention to provide a display device in which reference voltage is efficiently supplied to a display region.

Another aspect of the present invention is to provide a method of fabricating a display device in which a reference voltage is efficiently supplied to a display region.

An exemplary embodiment of a display device includes a substrate including a display region, and a reference voltage supplying unit disposed along at least one side of the display region which supplies a reference voltage to the display region, wherein the reference voltage supplying unit includes; a first sub-supplying unit including a first voltage applying region which supplies the reference voltage to the display region, a first insulating layer disposed on the first sub-supplying unit, and a second sub-supplying unit disposed on the first insulating layer and including a second voltage applying region which supplies the reference voltage to the display region.

According to an exemplary embodiment of the present invention, the first-sub supplying unit and the second sub-supplying unit are disposed as separate units which do not directly contact each other.

According to an exemplary embodiment of the present invention, the first-sub supplying unit and the second sub-supplying unit partially overlap each other.

According to an exemplary embodiment of the present invention, the display device further includes a second insulating layer disposed on the second sub-supplying unit.

According to an exemplary embodiment of the present invention, the first insulating layer and the second insulating layer include a first contact hole which exposes the first voltage applying region, and the second insulating layer includes a second contact hole which exposes the second voltage applying region.

According to an exemplary embodiment of the present invention, the display device further includes a contact member which covers the first and second voltage applying regions and includes a transparent conductive material.

According to an exemplary embodiment of the present invention, the reference voltage includes a common voltage, and the display device further includes a common electrode receiving the common voltage through the contact member.

According to an exemplary embodiment of the present invention, the first and second insulating layers are formed with a contact hole through which the first voltage applying region is exposed, the reference voltage includes a driving voltage, and the display device further includes a driving voltage line which receives the driving voltage through the contact hole.

According to an exemplary embodiment of the present invention, the driving voltage line and the second sub-supplying unit include substantially the same material and are disposed on the same layer of the display device.

According to an exemplary embodiment of the present invention, the first sub-supplying unit includes a first pad disposed outside of the display region, and the second sub-supplying unit includes a second pad adjacent to the first pad, and the first pad and the second pad are connected to the same power supplying unit.

According to an exemplary embodiment of the present invention, the first voltage applying region and the second voltage applying region are alternately and repetitively disposed along a first side of the reference voltage supplying unit, wherein the first side is disposed opposite the display region.

An exemplary embodiment of a display device includes; a substrate including a display region and a non-display region, and a common voltage supplying unit disposed along at least one side of the display region and which supplies a common voltage to the display region, wherein the common voltage supplying unit includes; a first sub-supplying unit including a first voltage applying region which supplies the common voltage to the display region, a first insulating layer disposed on the first sub-supplying unit, and a second sub-supplying unit disposed on the first insulating layer and including a second voltage applying region which supplies the common voltage to the display region, wherein the first insulating layer and the second insulating layer include a first contact hole which exposes the first voltage applying region, and the second insulating layer further includes a second contact hole which exposes the second voltage applying region.

According to an exemplary embodiment of the present invention, the first-sub supplying unit and the second sub-supplying unit are disposed as separate units which partially overlap, but do not directly contact each other.

According to an exemplary embodiment of the present invention, the display device further includes a contact member which covers the first and second voltage applying regions and includes a transparent conductive material.

According to an exemplary embodiment of the present invention, the first sub-supplying unit includes a first pad disposed in the non-display region, and the second sub-supplying unit includes a second pad adjacent to the first pad, and the first pad and the second pad are connected to the same power supplying unit.

According to an exemplary embodiment of the present invention, the first voltage applying region and the second voltage applying region are alternately and repetitively disposed along a first side of the common voltage supplying unit, wherein the first side is disposed opposite the display region.

Another exemplary embodiment of a display device includes; a substrate including a display region, and a reference voltage supplying unit disposed along at least one side of the display region which supplies a reference voltage to the display region, wherein the reference voltage supplying unit includes at least two metal layers which are separated from each other.

An exemplary embodiment of a method of fabricating an exemplary embodiment of a display device includes; disposing a first sub-supplying unit including a first pad and a first voltage supplying region, disposing a first insulating layer on the first sub-supplying unit, disposing a second sub-supplying unit including a second pad and a second voltage supplying region on the first insulating layer, disposing a second insulating layer on the second sub-supplying unit, forming a first contact hole on a first voltage supplying region and a second contact hole on a second voltage supplying region, and electrically connecting a common electrode to the first voltage supplying region and the second voltage supplying region through the first contact hole and the second contact hole.

According to an exemplary embodiment of the present invention, the first sub-supplying unit and the second sub-supplying unit are disposed adjacent to each other.

According to an exemplary embodiment of the present invention, the first voltage supplying region and the second voltage supplying region are alternately and repetitively disposed along the length of the first and second sub-supplying units.

According to another exemplary embodiment of the present invention, the method further includes supplying a voltage to the first and second sub-supplying units through the first and second pads.

According to another exemplary embodiment of the present invention, the disposing a first sub-supplying unit includes depositing and patterning a first metal layer on an insulating substrate, the disposing a second sub-supplying unit includes depositing and patterning a second metal layer on the first insulating layer, and the forming a first contact hole includes patterning the first insulating layer and the second insulating layer at substantially the same time.

### BRIEF DESCRIPTION OF THE DRAWINGS

The above and/or other aspects and advantages of the present invention will become apparent and more readily appreciated from the following description of the exemplary embodiments, taken in conjunction with the accompanying drawings of which:
FIG. 1 is an equivalent circuit diagram of an exemplary embodiment of a pixel in a first exemplary embodiment of a display device according to the present invention;
FIGS. 2 and 3 are top plan layout diagrams of the first exemplary embodiment of a display device according to the present invention;
FIG. 4 is a top plan layout view of an exemplary embodiment of a common voltage supplying unit in the exemplary embodiment of a display device according to the present invention;
FIG. 5 is an enlarged view of the region 'A' in FIG. 4;
FIG. 6 is a cross-sectional view taken along line VI-VI in FIG. 4;
FIG. 7 is a cross-sectional view taken along line VII-VII in FIG. 4;
FIG. 8 is a cross-sectional view taken along line VIII-VIII in FIG. 5;
FIGS. 9A through 13B are cross-sectional views illustrating an exemplary embodiment of a method of manufacturing the first exemplary embodiment of a display device according to the present invention;
FIG. 14 is a cross-sectional view of a second exemplary embodiment of a display device according to the present invention;
FIG. 15 is a top plan layout view of an exemplary embodiment of a common voltage supplying unit in a third exemplary embodiment of a display device according to the present invention;
FIG. 16 is a cross-sectional view taken along line XVI-XVI in FIG. 15;
FIGS. 17 and 18 are top plan layout diagrams of a fourth exemplary embodiment of a display device according to the present invention;
FIG. 19 illustrates an exemplary embodiment of a common voltage supplying unit in the fourth exemplary embodiment of a display device according to the present invention;
FIG. 20 is a cross-sectional view taken along line XX-XX in FIG. 19; and
FIG. 21 illustrates an exemplary embodiment of a driving voltage supplying unit in a fifth exemplary embodiment of a display device according to the present invention.

### DETAILED DESCRIPTION OF THE INVENTION

The invention now will be described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another elements as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments of the present invention are described herein with reference to cross section illustrations that are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present invention.

Hereinafter, the present invention will be described in detail with reference to the accompanying drawings.

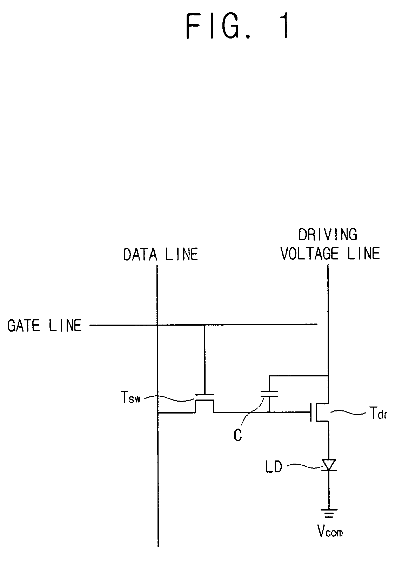

FIG. 1 is an equivalent circuit diagram of an exemplary embodiment of a pixel in a first exemplary embodiment of a display device according to the present invention.

As shown in FIG. 1, one pixel is provided with a plurality of signal lines. The signal lines comprise a gate line transmitting a scanning signal, a data line transmitting a data signal, and a driving voltage line transmitting a driving voltage. The data line and the driving voltage line are arranged adjacent to and substantially parallel to each other. The gate line is formed substantially perpendicularly to the data line and the driving voltage line.

Each pixel comprises an organic light emitting element LD, a switching thin film transistor ("TFT") Tsw, a driving TFT Tdr and a capacitor C.

The driving TFT Tdr comprises a control terminal connected to the switching TFT Tsw, an input terminal connected to the driving voltage line, and an output terminal connected to the organic light emitting element LD.

The organic light emitting element LD comprises an anode connected to the output terminal of the driving TFT Tdr and a cathode connected to a common voltage line Vcom. The organic light emitting element LD emits light with a brightness depending on the intensity of an output current from the driving TFT Tdr. A plurality of light emitting elements may emit light of varying intensity in a pattern, thereby displaying images. The intensity of the current transmitted from the driving TFT Tdr to the light emitting elements LD varies depending on a voltage differential between the control terminal and the output terminal of the driving TFT Tdr.

The switching TFT Tsw comprises a control terminal connected to the gate line, an input terminal connected to the data line, and an output terminal connected to the control terminal of the driving TFT Tdr. The switching TFT Tsw receives the data signal from the data line and transmits it to the driving TFT Tdr in response to the scanning signal applied to the gate line.

The capacitor C is connected between the control terminal and the input terminal of the driving TFT Tdr. The capacitor C charged with the data signal maintains the voltage thereof to be input to the control terminal of the driving thin film transistor Tdr.

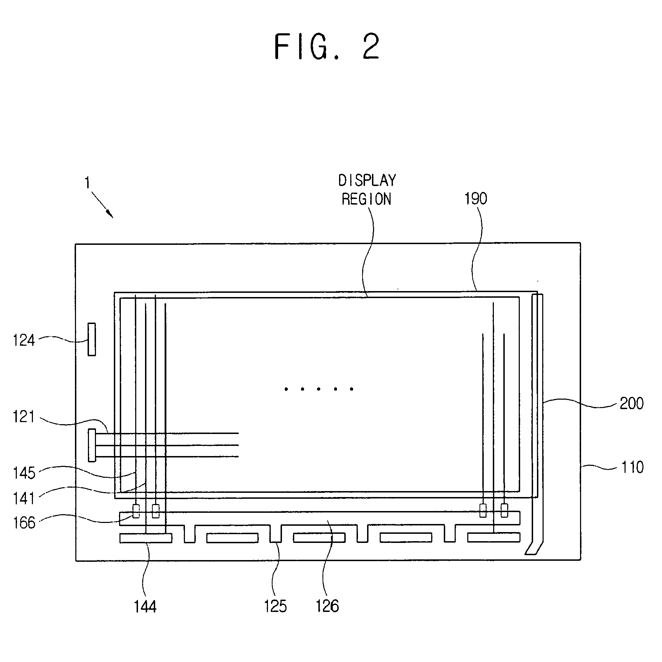

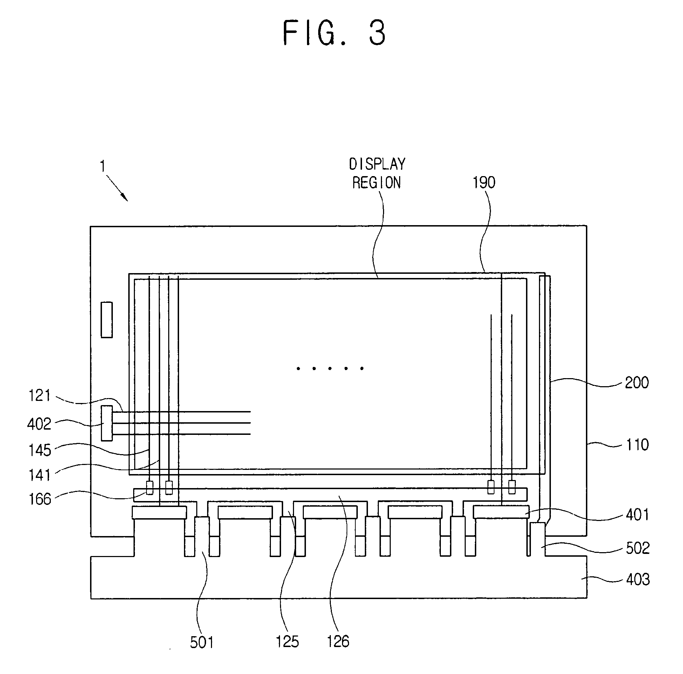

The first exemplary embodiment of a display device according to the present invention will be described with reference to FIGS. 2 and 3. FIGS. 2 and 3 are top plan layout diagrams of the first exemplary embodiment of a display device according to the present invention. In FIGS. 2 and 3 the first exemplary embodiment of a display device is illustrated without a driving chip and a power supply.

An insulating substrate 110 comprises a rectangular display region and a non-display region surrounding the display region.

First, the non-display region is described below.

The portion of the non-display region located below the display region is provided with a data pad 144, which provides a contact area for connecting a data driving chip 401, and a data line 141 extended into the display region.

The plurality of data pads 144 are spaced at a regular distance apart, and driving voltage pads 125 are provided in spaces between two adjacent data pads 144. The driving voltage pad 125 receives a driving voltage from a circuit board 403 through a driving voltage transmitter 501.

Each driving voltage pad 125 is connected to a driving voltage bar 126 disposed substantially in parallel with a gate line 121. The driving voltage bar 126 is connected with the driving voltage line 145 extending substantially in parallel with the data line 141.

In one exemplary embodiment the driving voltage bar 126 and the driving voltage line 145 are formed in different layers. The driving voltage bar 126 and the driving voltage line 145 are connected by a bridge part 166. In one exemplary embodiment the bridge part 166 is made of a transparent conductive material. Contact holes (not shown) are formed on the driving voltage bar 126 and the driving voltage line 145, respectively, so that a connection therebetween may be formed through the bridge part 166.

The non-display region to the left of the display region is provided with a gate pad 124 connected to the gate line 121.

A gate driving chip 402 receives a driving signal from the circuit board 403 through a wiring line (not shown) formed on the insulating substrate 110.

Referring to FIG. 3, in one exemplary embodiment the driving chips 401 and 402 are mounted in a chip on glass ("COG") format on the data pad 144 and the gate pad 124. However, alternative exemplary embodiments include different configurations and the present invention is not limited to the COG format. In one alternative exemplary embodiment, the driving chips 401 and 402 may be mounted on films, and the films can be connected to the pads 124 and 144, respectively.

The non-display region to the right of the display region is provided with a common voltage supplying unit 200. The common voltage supplying unit 200 extends in a direction substantially parallel with the data line 141, and one end thereof is connected to a common voltage transmitting unit 502.

The common voltage supplying unit 200 partially overlaps a common electrode 190 and supplies the common voltage to the common electrode 190. Exemplary embodiments of the structure of the common voltage supplying unit 200 and a method of supplying a common voltage with the voltage supplying unit 200 will be described in more detail below.

In the present exemplary embodiment there is no specific structure in the non-display region above the display region.

In the above-described first exemplary embodiment of a display device 1, the circuit board 403 is attached to one side of the insulating substrate 110. In other words, the first exemplary embodiment of a display device 1 does not comprise additional circuit boards for driving the gate driving chip 402 or supplying the common voltage. Thus, the first exemplary embodiment of a display device 1 according to the present invention has a relatively simple configuration.

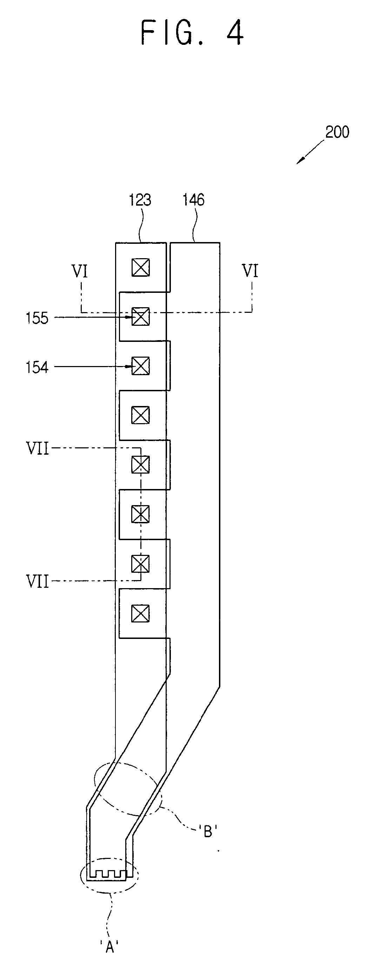

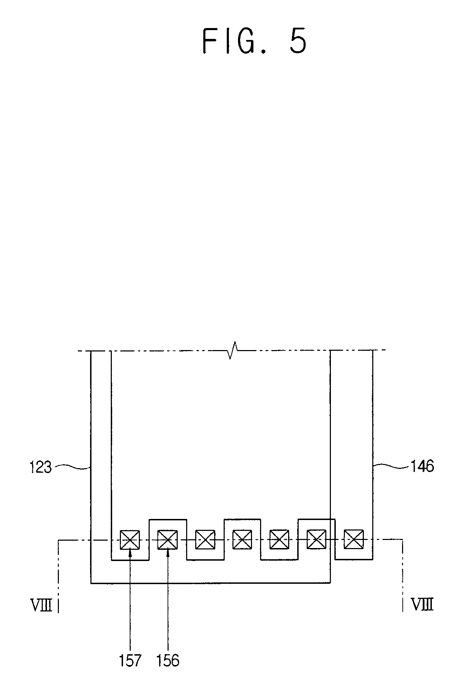

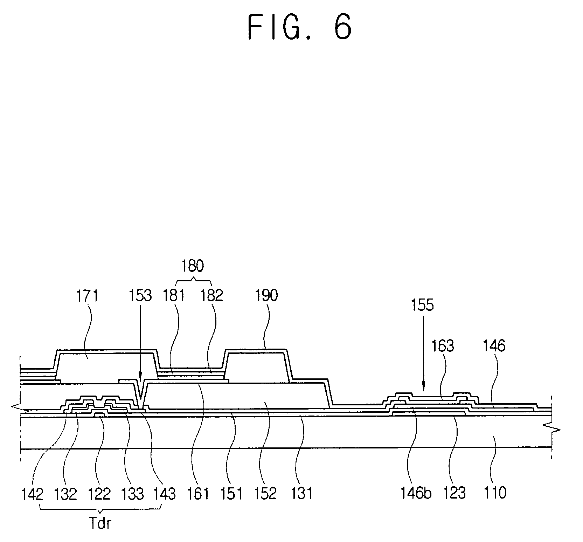

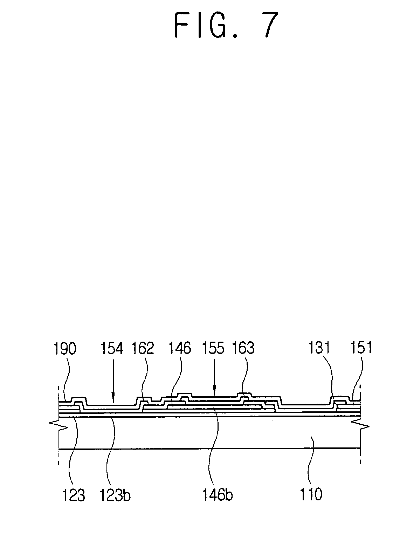

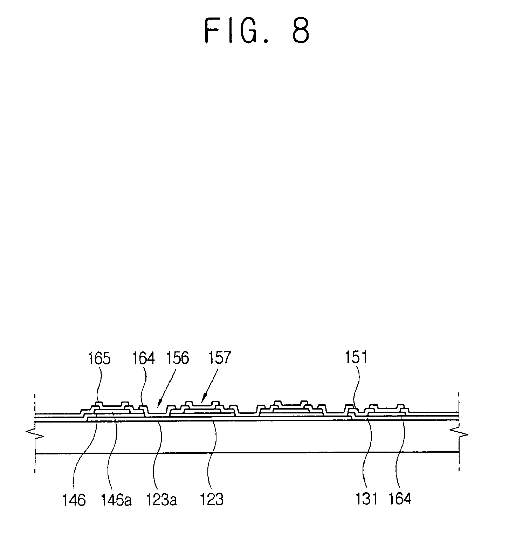

The common voltage supplying unit 200 and the display region will be described with reference to FIGS. 4 through 8. FIG. 4 is a top plan layout view of an exemplary embodiment of a common voltage supplying unit in the first exemplary embodiment of a display device according to the present invention; FIG. 5 is an enlarged view of the region 'A' in FIG.. 4; FIG. 6 is a cross-sectional view taken along line VI-VI in FIG. 4; FIG. 7 is a cross-sectional view taken along line VII-VII in FIG. 4; and FIG. 8 is a cross-sectional view taken along line VIII-VIII in FIG. 5. FIG. 6 illustrates only the driving TFT Tdr.

Referring to FIGS. 2-6, the gate line 121 and a gate electrode 122 are formed on the insulating substrate 110. Exemplary embodiments of the insulating substrate 110 are made of an insulating material such as glass, quartz, ceramic or plastic. The gate line 121 and the gate electrode 122 are formed on the same metal layer as a first sub-supplying unit 123, the gate pad 124, the driving voltage pad 125 and the driving voltage bar 126. In the present exemplary embodiment the gate line 121 is connected to the gate pad 124.

A gate insulating layer 131, exemplary embodiments of which may be made of silicon nitride ("SiNx"), is formed on the gate line 121 and the gate electrode 122. A semiconductor layer 132 and an ohmic contact layer 133 are sequentially formed on the gate insulating layer 131 above the gate electrode 122. Exemplary embodiments of the semiconductor layer 132 may be made of amorphous silicon, and exemplary embodiments of the ohmic contact layer 133 may be made of n+ hydrogenated amorphous silicon which is highly doped with n-type impurities. The ohmic contact layer 133 is divided into two parts, with the gate electrode 122 interposed therebetween.

A source electrode 142, a drain electrode 143 and a second sub-supplying unit 146 are formed on the ohmic contact layer 133 and the gate insulating layer 131. The source electrode 142 and the drain electrode 143 are separated from each other, with the gate electrode 122 interposed therebetween. In one exemplary embodiment the source electrode 142, the drain electrode 143 and the second sub-supplying unit 146 are formed on the same metal layer as the data line 141, the driving voltage line 145 and the data pad 144.

A passivation layer 151 is formed on the source electrode 142, the drain electrode 143 and the semiconductor layer 132 which is exposed between the source electrode 142 and the drain electrode 143. In one exemplary embodiment the passivation layer 151 may be made of silicon nitride ("SiNx").

An exemplary embodiment of the common voltage supplying unit 200 of FIG.4 will be described in more detail.

Referring to FIGs. 5 and 6, the common voltage supplying unit 200 extends substantially in parallel with the data line 141, and comprises the first sub-supplying unit 123 and the second sub-supplying unit 146. The first sub-supplying unit 123 and the second sub-supplying unit 146 overlap, but are separated from, each other, with the gate insulating layer 131 interposed therebetween. The second sub-supplying unit 146 is placed adjacent to the first sub-supplying unit 123 and partially extending over the first sub-supplying unit 123.

As shown in FIGS. 3, 4 and 8, the first sub-supplying unit 123 includes a first pad 123a at an end thereof, and the second sub-supplying unit 146 includes a second pad 146a at an end thereof. The first pad 123a and the second pad 146a are alternatingly disposed, and receive the common voltage from the circuit board 403 through the common voltage transmitting unit 502 of FIG. 3. Although three contact holes 156 exposing first pads 123a and four contact holes 157 exposing second pads 146a are shown alternative exemplary embodiments may include a greater or lesser number of either contact holes or pads.

Referring to FIG. 7, the passivation layer 151 is formed with contact holes 154 and 155 through which the first and second sub-supplying units 123 and 146 are exposed. The gate insulating layer 131 is removed where the contact hole 154 exposing the first sub-supplying unit 123 is formed. A portion of the first sub-supplying unit 123 exposed through the contact hole 154 serves as a first voltage applying region 123b, and a portion of the second sub-supplying unit 146 exposed through the contact hole 155 serves as a second voltage applying region 146b. The first voltage applying region 123b and the second voltage applying region 146b are alternately disposed along a lengthwise direction of the common voltage supplying unit 200. Although four contact holes 154 exposing first voltage applying regions 123b and four contact holes 155 exposing second voltage applying regions 146b are shown alternative exemplary embodiments may include a greater or lesser number of contact holes and voltage applying regions.

Referring to FIGs. 5 and 8, the passivation layer 151 covering an end of the common voltage supplying unit 200 is formed with contact holes 156 and 157 to expose the first and second pads 123a and 146a, respectively. The gate insulating layer 131 is also removed in a place where the contact hole 156 is formed.

The passivation layer 151 and a planarization layer 152 (to be described later) are removed in the contact hole 153, and therefore the contact hole 153 exposes the drain electrode 143 therethrough.

The planarization layer 152 is formed on the passivation layer 151. Exemplary embodiments of the planarization layer 152 include one of benzocyclobutene ("BCB"), olefin, acrylic resin, polyimde, Teflon^{™}, Cytop^{™} and perfluorocyclobutene ("FCB").

A pixel electrode 161 is formed on the planarization layer 152. The pixel electrode 161 provides a hole to an organic layer 180, wherein holes and electrons are combined to form excitons in the organic layer 180. Exemplary embodiments of the pixel electrode 161 are made of a transparent conductive material such as indium tin oxide ("ITO") or indium zinc oxide ("IZO"). The pixel electrode 161 is connected to the drain electrode 143 through the contact hole 153.

Contact members 162, 163, 164 and 165 are formed on the exposed first voltage applying region 123b, the exposed second voltage applying region 146b, the exposed first pad 123a and the exposed second pad 146a, respectively. In one exemplary embodiment the contact members 162, 163, 164 and 165 are formed on the same layer as the pixel electrode 161. Additionally, in one exemplary embodiment the bridge part 166 (as shown in FIG. 2) of the non-display region is formed on the same layer as the pixel electrode 161.

Referring to FIG. 6, a partition wall 171 is formed on the pixel electrode 161 and the planarization layer 152, and surrounds the pixel electrode 161. The partition wall 171 partitions the pixel electrodes 161 to define a pixel region. The partition wall 171 prevents the source electrode 142 and the drain electrode 143 of the TFT Tdr from being short-circuited with the common electrode 190. In one exemplary embodiment the partition wall 171 is made of a photoresist material with thermal resistance and solvent resistance such as acrylic resin, polyimide resin, or other similar materials, or an inorganic material such as silicon dioxide ("SiO₂"), titanium dioxide ("TiO₂"), or other similar materials. Alternative exemplary embodiments include configurations wherein the partition wall 171 has a double-layered structure of an organic layer and an inorganic layer.

The organic layer 180 is formed on the pixel electrode 161 and comprises a hole injecting layer 181 and a light emitting layer 182.

Alternative exemplary embodiments include configurations wherein the organic layer 180 also includes any one or more of a hole transportation layer, an electron injection layer and an electron transportation layer.

Exemplary embodiments of the hole injecting layer 181 include compounds of poly thiophene derivatives such as poly-3,4-ethylenedioxythiophene ("PEDOT"), and other similar materials, and poly styrenesulfonate ("PSS"), and other similar materials.

The light emitting layer 182 comprises a red light emitting layer, a green light emitting layer and a blue light emitting layer. However, in the present exemplary embodiment only one color light emitting layer is formed in each pixel. Groups of pixels with red, green and blue light emitting layers are formed repeatedly across the display device. In an alternative exemplary embodiment the light emitting layer 182 of a single pixel emits a white colored light and color filters (not shown) are provided on the organic layer 180 to produce groups of red, green and blue pixels repeatedly across the display device.

In one exemplary embodiment the light emitting layer 182 may comprise polyfluorene derivatives, poly paraphenylene vinylene derivatives, polyphenylene derivatives, poly vinylcarbazole derivatives and poly thiophene derivatives, macro molecular materials doped with a perillene group pigment, a rothermine group pigment, rubrene, perillene, 9,10-diphenylanthracene, tetraphenylbutadiene, Nile red, cumarine 6, quinacridone and various other materials.

Holes provided from the pixel electrode 161 and electrons provided from the common electrode 190 are combined into excitons in the light emitting layer 182. The excitons then generate light through a de-excitation process.

The common electrode 190 is formed on the partition wall 171 and the organic layer 180. The common electrode 190 provides the electrons to the light emitting layer 182. In one exemplary embodiment the common electrode 190 may have a double-layered structure of a lithium fluoride layer and an aluminum layer. When the common electrode 190 is made of an opaque material such as aluminum, silver or the like, light from the light emitting layer 182 is emitted toward the insulating substrate 110, in what is called a bottom-emission type.

In the first exemplary embodiment of a display device 1, the organic layer 180 is vulnerable to moisture and oxygen, and in one exemplary embodiment the display device 1 further comprises an encapsulation plate (not shown).

In the first exemplary embodiment of a display device 1 according to the present invention, a method of supplying the common voltage to the common electrode 190 will be described below.

The common voltage from the circuit board 403 is supplied from to the common voltage supplying unit 200 via the common voltage transmitting unit 502. The common voltage transmitting unit 502 is electrically connected to the contact members 164 and 165 covering the pads 123a and 146a of the common voltage supplying unit 200. In one exemplary embodiment an anisotropic conductive film (not shown) may be interposed between the common voltage transmitting unit 502 and the contact members 164 and 165 to facilitate electrical contact therebetween.

The common voltage is supplied to the first and second sub-supplying units 123 and 146 through the pads 123a and 146a, respectively. The common voltage is supplied to the common voltage supplying unit 200 by a path which is divided into two by the first and second sub-supplying units 123 and 146. Thus, it is possible to supply the common voltage evenly to the display even though a part (particularly, a part of 'B') of the common voltage supplying unit 200 is narrow due to design limitations of the display. Problems of locally increased temperature and voltage drop in the common voltage supplying unit 200 can be solved because the common voltage is supplied evenly thereto.

The common voltage applied to the common voltage supplying unit 200 is supplied to the common electrode 190 through the first and second voltage applying regions 123b and 146b. The common electrode 190 contacts the contact members 162 and 163 covering the respective voltage applying regions 123b and 146b through the contact holes 154 and 155, respectively, and receives the common voltage therefrom.

Thus, the common electrode 190 receives a constant voltage from the common voltage supplying unit 200, and the quality of a displayed image is improved.

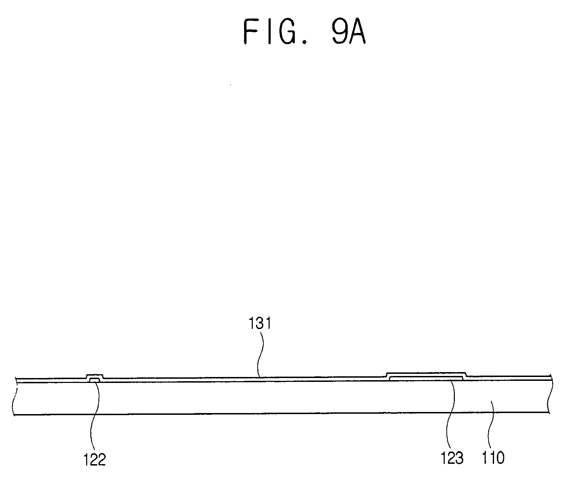

Below, a first exemplary embodiment of a method of fabricating the first exemplary embodiment of a display device according to the present invention will be described with reference to FIGS. 9A through 13B. FIGS. 9A, 10A, 11A, 12A and 13A are cross-sectional views taken along line VI-VI in FIG. 4, and FIGS. 9B, 10B, 11B, 12B and 13B are cross-sectional views taken along line VII-VII in FIG. 4.

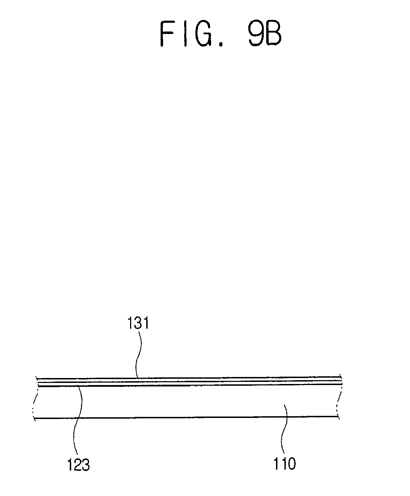

Referring to FIGS. 9A and 9B, the gate electrode 122 and the first sub-supplying unit 123 are formed, and the gate insulating layer 131 is then formed on the gate electrode 122 and the first sub-supplying unit 123. In one exemplary embodiment the gate electrode 122 and the first sub-supplying unit 123 are formed by patterning the same metal layer. In one exemplary embodiment the gate insulating layer 131 can include silicon nitride and be formed by a chemical vapor deposition ("CVD") method.

Although not illustrated with respect to the cross-sectional areas shown in FIGS. 9A and 9B, the gate line 121, the gate pad 124, the driving voltage pad 125 and the driving voltage bar 126 are formed along with the gate electrode 122 and the first sub-supplying unit 123.

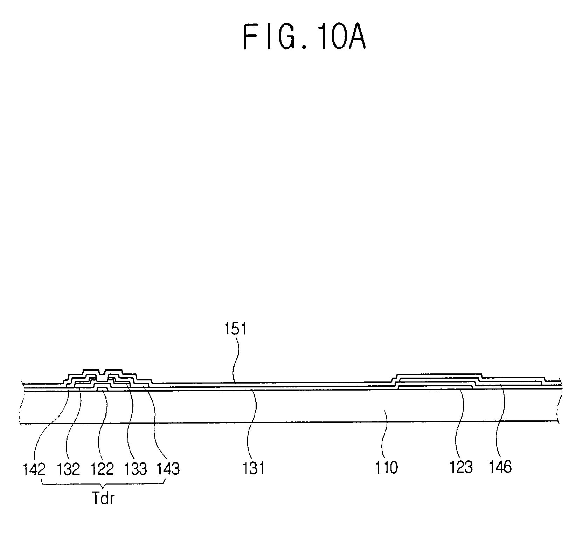

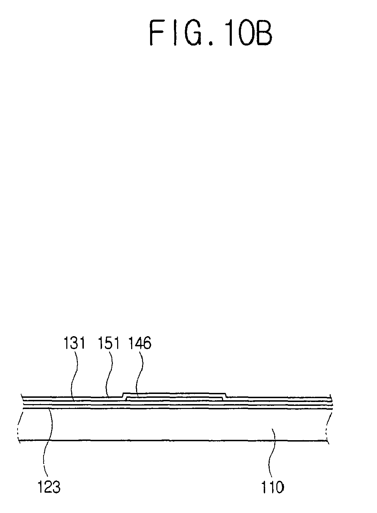

Then, as shown in FIGS. 10A and 10B, the semiconductor layer 132, the ohmic contact layer 133, the source electrode 142 and the drain electrode 143 are formed to fabricate the driving thin film transistor Tdr. The passivation layer 151 is formed on the driving TFT Tdr. In one exemplary embodiment the passivation layer 151 can include silicon nitride and be formed by the CVD method.

The gate insulating layer 131, the semiconductor layer 132 and the ohmic contact layer 133 can be deposited one after the other. The second sub-supplying unit 146 is formed on the first sub-supplying unit 123. In one exemplary embodiment the second sub-supplying unit 146 is formed from the same layer as the source electrode 142 and the drain electrode 143.

The first sub-supplying unit 123 is partially overlapped by the second sub-supplying unit 146, however, they do not contact each other because the second sub-supplying unit 146 is formed on the gate insulating layer 131 covering the first sub-supplying unit 123.

Furthermore, the data line 141, the data pad 144 and the driving voltage line 145 are formed along with the source electrode 142, the drain electrode 143 and the second sub-supplying unit 146, which is not shown in the cross-sectional views illustrated herein.

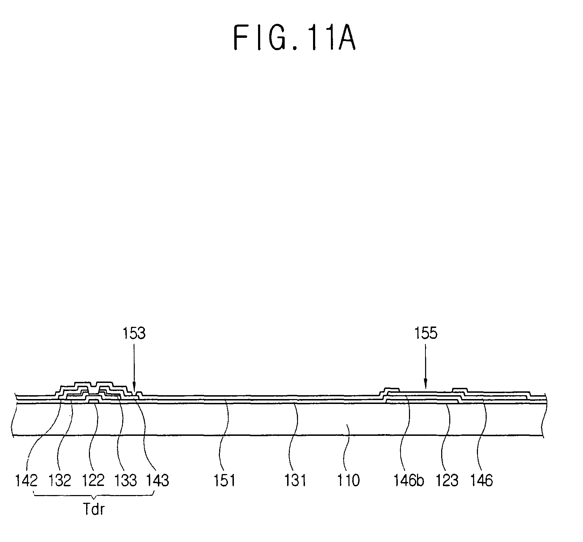

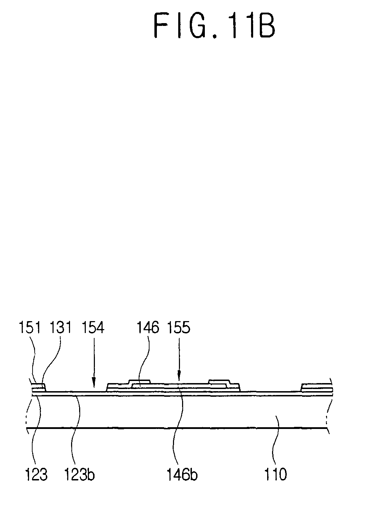

Then, as shown in FIGS. 11A and 11B, the gate insulating layer 131 and the passivation layer 151 are patterned to form the contact holes 153, 154, 155 through which the drain electrode 143, the first sub-supplying unit 123 and the second sub-supplying unit 146 are exposed, respectively. One exemplary embodiment of a method of patterning the gate insulating layer 131 and the passivation layer 151 is through photolithography, but the present invention is not limited thereto.

The drain electrode 143 and the second sub-supplying unit 146 are exposed by the removal of the passivation layer at the contact holes 153 and 155. The first sub-supplying unit 123 is exposed by the removal of both the gate insulating layer 131 and the passivation layer 151 at the contact hole 154.

The first and second voltage applying regions 123b and 146b are defined by the contact holes 154 and 155 which expose the first and second sub-supplying units 123 and 146, respectively. In the present exemplary embodiment, the first and second voltage applying regions 123b and 146b are alternately disposed along the lengthwise direction of the common voltage supplying unit 200.

While the gate insulating layer 131 and the passivation layer 151 are patterned, the contact holes 156 and 157 are formed to expose the first and second pads 123a and 146a, respectively, which is not shown in the cross-sectional views illustrated herein.

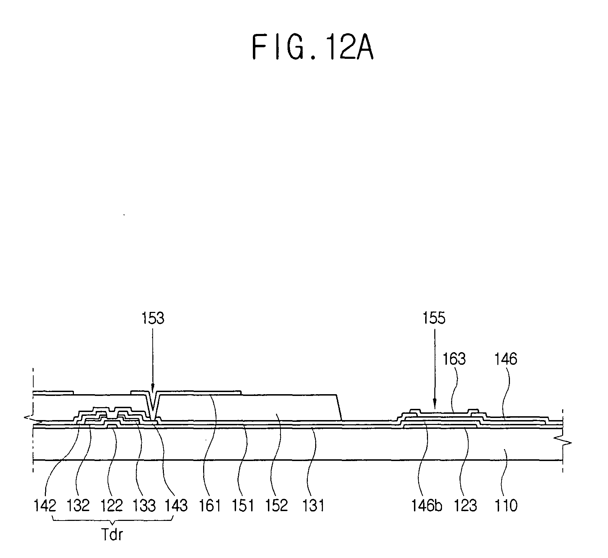

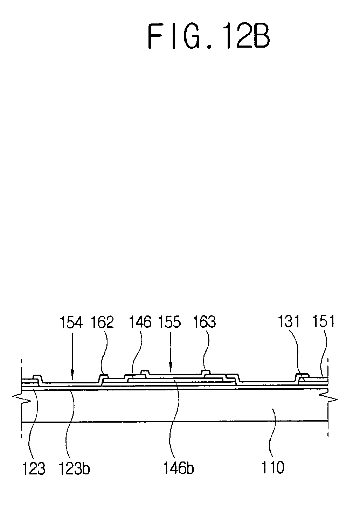

Then, as shown in FIGS. 12A and 12B, the planarization layer 152 is formed, and the pixel electrode 161 and the contact members 162 and 163 are formed.

In one exemplary embodiment the planarization layer 152 can be formed by a slit-coating method, a spin-coating method, a screen-coating method, or other similar methods. The planarization layer 152 is not formed on the common voltage supplying unit 200, and is partially removed where the contact hole 153 exposes the drain electrode 143.

In one exemplary embodiment the pixel electrode 161 and the contact members 161 and 163 are formed on the same layer by depositing and patterning a transparent conductive material.

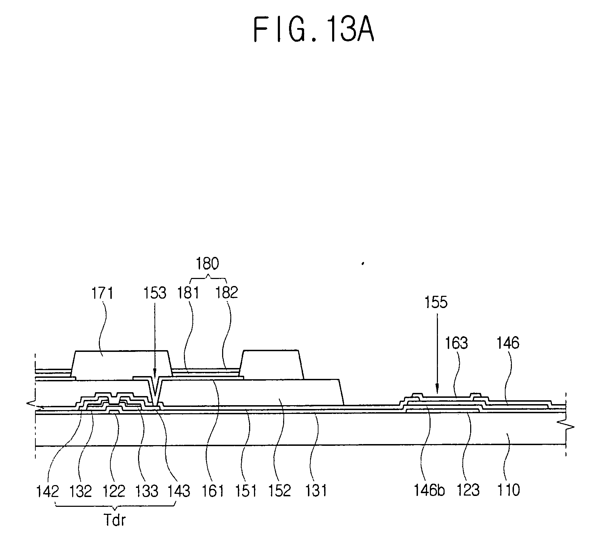

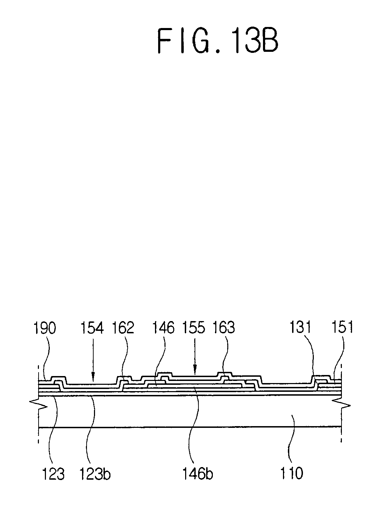

Then, as shown in FIGS. 13A and 13B, the partition wall 171 and the organic layer 180 are formed.

In one exemplary embodiment the partition wall 171 is formed by coating, exposing and developing the photoresist material. In such an exemplary embodiment, the coating method includes the spin-coating method, the slit-coating method or the screen-coating method.

In one exemplary embodiment the organic layer 180 can be formed by an inkjet method as described below.

To form the hole injecting layer 181, a hole injecting ink is dropped by the inkjet method on the pixel electrode 161 surrounded with the partition wall 171. In one exemplary embodiment the hole injecting ink includes poly thiophene derivatives such as poly-3,4-ethylenedioxythiophene ("PEDOT"), or various other similar materials; poly styrenesulfonate ("PSS"); and a solvent.

Then, the hole injecting ink is dried to form the hole injecting layer 181. In one exemplary embodiment the hole injecting ink can be dried by a relatively low pressure of 1Torr at room temperature under a nitrogen atmosphere. If the pressure is too low, the hole injecting ink may boil violently. Further, if the temperature is higher than the room temperature, the solvent may be rapidly evaporated and it is difficult to make the thickness of the hole injecting layer 181 uniform.

In one exemplary embodiment after the hole injecting ink is completely dried, it can be annealed at a temperature of about 200 °C for about 10 minutes in the nitrogen atmosphere. In another exemplary embodiment the hole injecting ink can be annealed in a vacuum. Through this annealing process, the solvent or moisture remaining in the hole injecting layer 181 after the drying process is removed.

Then, a light emitting ink is dropped on the hole injecting layer 181 to form the light emitting layer 182. In one exemplary embodiment cyclohexylbenzene, dihydrobenzofuran, trimethylbenzene, tetramethylbenzene, or other similar substances are used as a solvent for the light emitting ink. The use of these substances has the additional benefit of preventing the hole injecting layer 181 from dissolving therein.

In a process similar to drying the hole injecting ink, the light emitting ink is dried to form the light emitting layer 182.

In one exemplary embodiment the common electrode 190 is formed on the organic layer 180 by orienting the insulating substrate 110 with the organic layer 180 facing downward and the common electrode is then formed thereon by an evaporation method through an open mask. Then, the first exemplary embodiment of a display device 1 is completed.

In such an exemplary embodiment, the forming region of the common electrode 190 is determined by the shape of an opening in the open mask. The common electrode 190 is formed throughout the display region and extends outward therefrom to electrically connect with the first and second voltage applying regions 123b and 146b in the non-display region.

The common electrode 190 contacts the contact members 162 and 163 and receives the common voltage from the first and second voltage applying regions 123b and 146b therethrough.

However, the above-mentioned first exemplary embodiment of a display device according to the present invention is not limited to that described above. In an alternative exemplary embodiment the organic layer 180 can be made of a low molecular weight material by the evaporation method. Further, in one exemplary embodiment the planarization layer 152 and/or the partition wall 171 may be partially formed on the common voltage supplying unit 200. In such an exemplary embodiment the planarization layer 152 and/or the partition wall 171 may be formed with additional contact holes exposing the contact members 162 and 163, and additional contact members may be formed to cover the additional contact holes.

The common voltage supplying unit 200 may vary, which will be described through second and third exemplary embodiments.

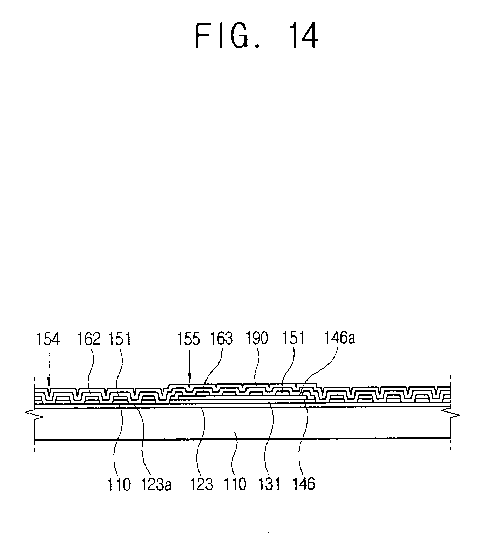

FIG. 14 is a cross-sectional view of a second exemplary embodiment of a display device according to the present invention, taken along line VII-VII in FIG. 4.

According to the second exemplary embodiment, contact holes 154 and 155 exposing first and second sub-supplying units 123 and 146 of a common voltage supplying unit 300 are increased in number and decreased in size as compared with those of the first exemplary embodiment. Additionally, in this second exemplary embodiment, the contact members 162 and 163 covering the contact holes 154 and 155 are formed as a single body.

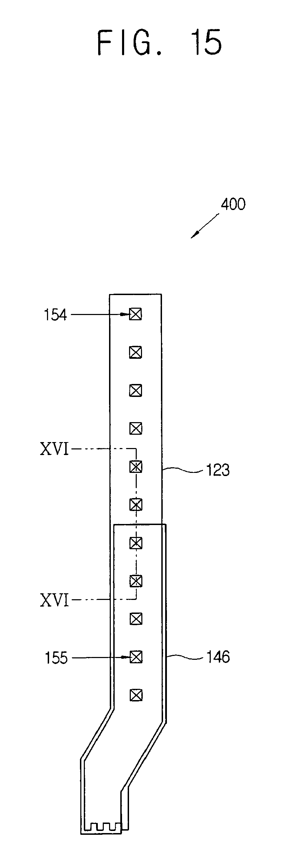

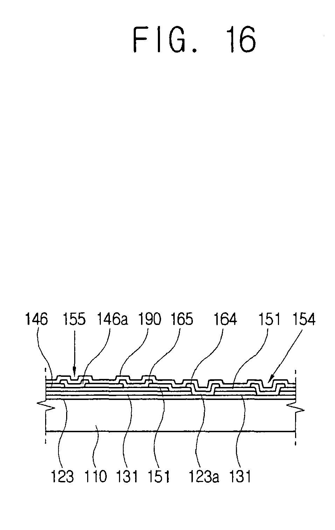

Below, third exemplary embodiment of a display device according to the present invention will be described with reference to FIGS. 15 and 16.

FIG. 15 is a top plan layout view of an exemplary embodiment of a common voltage supplying unit 400 in a third exemplary embodiment of a display device according to the present invention, and FIG. 16 is a cross-sectional view taken along line XVI-XVI in FIG. 15.

According to the third exemplary embodiment, the first sub-supplying unit 123 is formed with a greater length than a length of a second sub-supplying unit 146. A portion of the common electrode 190 in relative proximity to the common voltage transmitting unit 502 receives the common voltage through only the second sub-supplying unit 146. Portions of the common electrode 190 relatively distal from the common voltage transmitting unit 502 receive the common voltage through only the first sub-supplying unit 123.

The common voltage and the driving voltage are two reference voltages supplied to the display device 1. The present invention can be applied to applications applying a driving voltage, which will be described below through fourth and fifth exemplary embodiments.

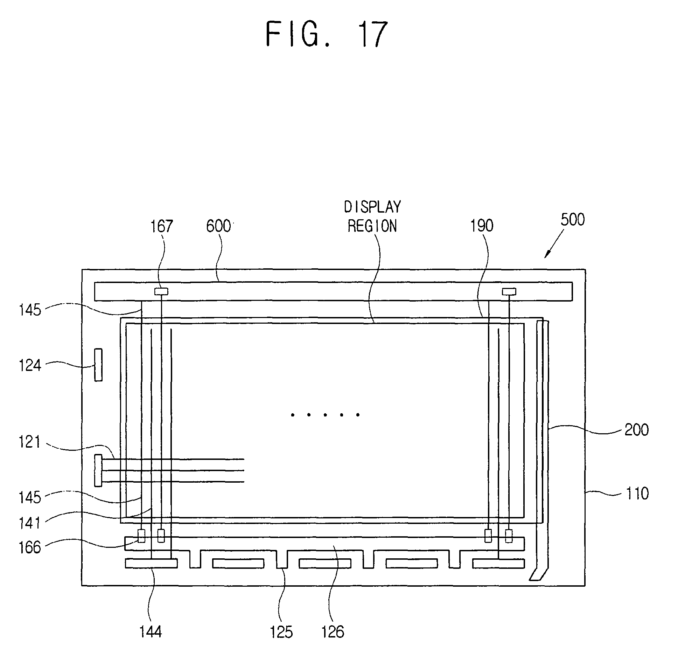

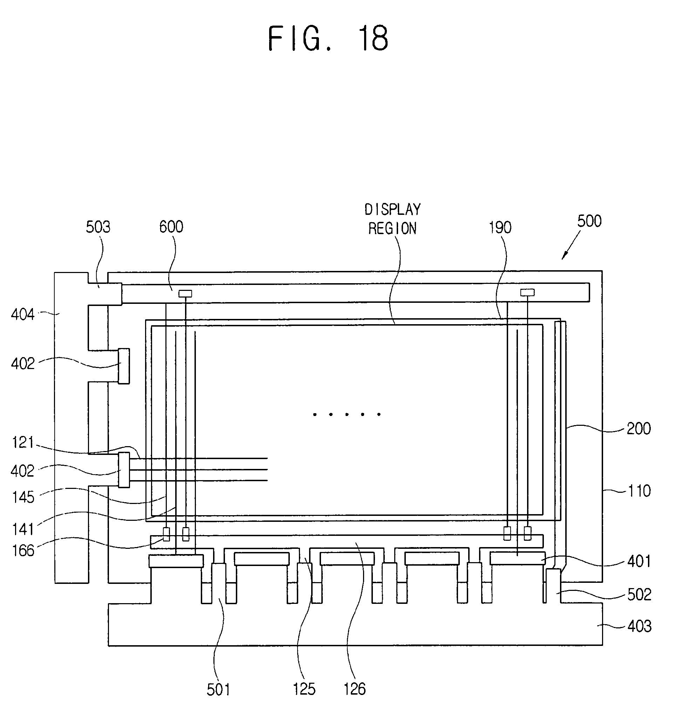

FIGS. 17 and 18 are top plan layout diagrams of a fourth exemplary embodiment of a display device 500 according to a fourth embodiment of the present invention. In FIG. 18, the display device is illustrated without a driving chip and a power supply.

In the fourth exemplary embodiment of a display device 500 according to the present invention, a driving voltage supplying unit 600 is provided in a non-display region located above a display region. A driving voltage line 145 has one end electrically connected to a driving voltage bar 126, and the other end electrically connected to the driving voltage supplying unit 600. Thus, the driving voltage line 145 receives the driving voltage through both ends thereof, so that the driving voltage line 145 maintains the driving voltage at a constant level irrespective of the position on the display device 500. Such a structure is especially suited for supplying a constant driving voltage for a long driving voltage line 145 of a large display device 1.

A gate circuit board 404 is connected to a gate driving chip 402 and applies a gate driving signal thereto. A driving voltage transmitting unit 503 transmits the driving voltage of the gate circuit board 404 to the driving voltage supplying unit 300.

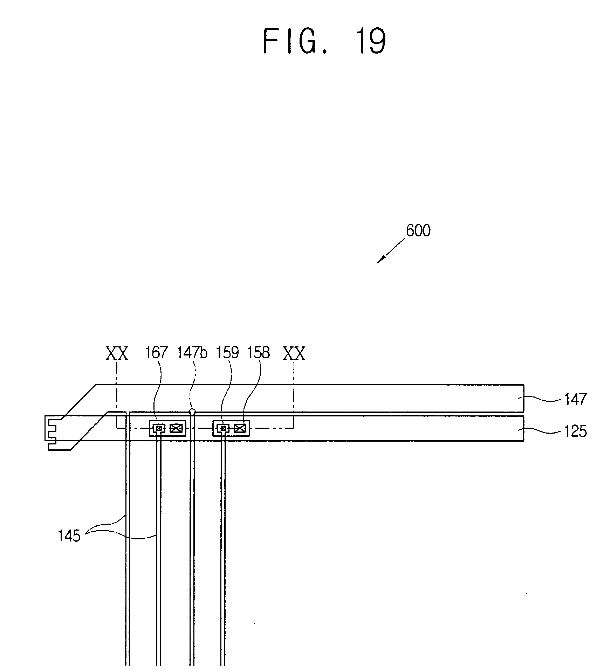

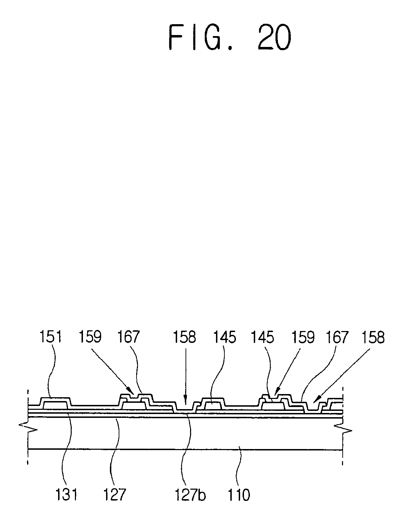

The driving voltage supplying unit 600 will be described with reference to FIGS. 19 and 20. FIG. 19 illustrates an exemplary embodiment of a common voltage supplying unit in the fourth exemplary embodiment of a display device 500 according to the present invention, and FIG. 20 is a cross-sectional view taken along line XX-XX in FIG. 20.

The driving voltage supplying unit 600 extends substantially in parallel with a gate line 121, and includes a first sub-supplying unit 127 and a second sub-supplying unit 147. The first sub-supplying unit 127 and the second sub-supplying unit 147 partially overlap each other, but are not in contact with each other due to an extension of the gate insulating layer 131 disposed therebetween. In the present exemplary embodiment the gate insulating layer 131 and a passivation layer 151 are patterned at substantially the same time.

The second sub-supplying unit 147 is disposed further from the display region than the first sub-supplying unit 125. However, the second sub-supplying unit 147 partially overlaps the first sub-supplying unit 125 in a region where both sub-supplying units 127 and 147 are connected with the driving voltage supplying unit 503.

One of a pair of adjacent driving voltage lines 145 is connected to the first sub-supplying unit 127, and the other of the pair of adjacent driving voltage lines 145 is connected to the second sub-supplying unit 147. This pattern is repeated for each of the driving voltage lines 145.

In this exemplary embodiment, the driving voltage line 145 and the first sub-supplying unit 127 are formed at different layers. Contact holes 158 and 159 are formed above the first sub-supplying unit 127 and the driving voltage line 145, respectively. The first sub-supplying unit 125 and the driving voltage line 145 are exposed through the contact holes 158 and 159 and are connected by a bridge part 167 which is disposed on the contact holes 158 and 159. In one exemplary embodiment the bridge part 167 is made of a transparent conductive material. In one exemplary embodiment the bridge part 167 can be formed on the same layer as a pixel electrode 161. A first voltage applying region 127b is defined by the contact hole 158 exposing the first sub-supplying unit 127.

In this exemplary embodiment, the driving voltage line 145 and the second sub-supplying unit 147 are disposed in the same metal layer. Therefore, the second sub-supplying unit 147 has no separate contact hole through which it can be connected with the driving voltage line 145. In other words, the second sub-supplying unit 147 and the driving voltage line 145 are formed as a single body, and the second voltage applying region 147b is formed where the driving voltage line 145 branches from the second sub-supplying unit 147. However, alternative exemplary embodiments include configurations wherein the second sub-supplying unit 147 and the driving voltage line 145 are formed from separate metal layers.

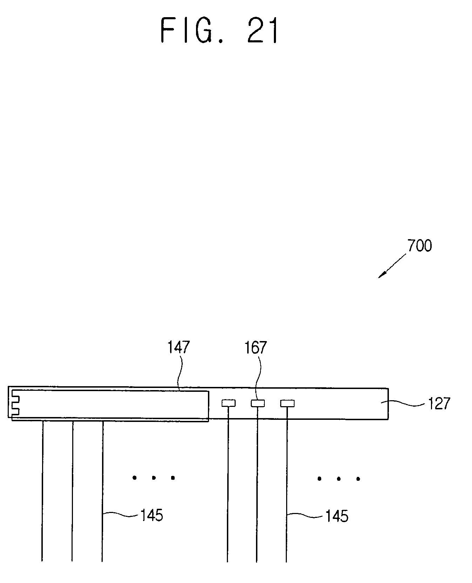

FIG. 21 illustrates an exemplary embodiment of a driving voltage supplying unit 700 in a fifth exemplary embodiment of a display device according to the present invention.

In the fifth exemplary embodiment, a first sub-supplying unit 127 is formed to be longer than a second sub-supplying unit 147. The driving voltage line 145 receives the driving voltage through the second sub-supplying unit 147 in a region in proximity to a driving voltage transmitting unit 503. The driving voltage line 145 receives the driving voltage through the first sub-supplying unit 127 in a region disposed distal to the driving voltage transmitting unit 503.

As described above, the present invention provides a display device in which reference voltages are efficiently supplied to a display region.

Furthermore, the present invention provides a method of fabricating a display device in which reference voltages are efficiently supplied to a display region.

Although a few exemplary embodiments of the present invention have been shown and described, it will be appreciated by those skilled in the art that changes may be made in these exemplary embodiments without departing from the principles and spirit of the present invention, the scope of which is defined in the appended claims and their equivalents.

## Claims

1. A display device comprising:
a substrate including a display region; and
a reference voltage supplying unit disposed along at least one side of the display region which supplies a reference voltage to the display region,
wherein the reference voltage supplying unit comprises:
a first sub-supplying unit including a first voltage applying region which supplies the reference voltage to the display region;
a first insulating layer disposed on the first sub-supplying unit; and
a second sub-supplying unit disposed on the first insulating layer and including a second voltage applying region which supplies the reference voltage to the display region.

2. The display device according to claim 1, wherein the first-sub supplying unit and the second sub-supplying unit are disposed as separate units which do not directly contact each other.

3. The display device according to claim 2, wherein the first-sub supplying unit and the second sub-supplying unit partially overlap each other.

4. The display device according to claim 2, further comprising a second insulating layer disposed on the second sub-supplying unit.

5. The display device according to claim 4, wherein the first insulating layer and the second insulating layer comprise a first contact hole which exposes the first voltage applying region, and
the second insulating layer comprises a second contact hole which exposes the second voltage applying region.

6. The display device according to claim 5, further comprising a contact member which covers the first and second voltage applying regions and includes a transparent conductive material.

7. The display device according to claim 6, wherein the reference voltage includes a common voltage, and
the display device further comprises a common electrode receiving the common voltage through the contact member.

8. The display device according to claim 4, wherein the first and second insulating layers are formed with a contact hole through which the first voltage applying region is exposed,
the reference voltage includes a driving voltage, and
the display device further comprises a driving voltage line which receives the driving voltage through the contact hole.

9. The display device according to claim 8, wherein the driving voltage line and the second sub-supplying unit comprise substantially the same material and are disposed on the same layer of the display device.

10. The display device according to claim 2, wherein the first sub-supplying unit comprises a first pad disposed outside of the display region, and the second sub-supplying unit comprises a second pad adjacent to the first pad, and
the first pad and the second pad are connected to the same power supplying unit.

11. The display device according to claim 2, wherein the first voltage applying region and the second voltage applying region are alternately and repetitively disposed along a first side of the reference voltage supplying unit,
wherein the first side is disposed opposite the display region.

12. A display device comprising:
a substrate including a display region and a non-display region; and
a common voltage supplying unit disposed along at least one side of the display region which supplies a common voltage to the display region,
wherein the common voltage supplying unit comprises:
a first sub-supplying unit including a first voltage applying region which supplies the common voltage to the display region;
a first insulating layer disposed on the first sub-supplying unit; and
a second sub-supplying unit disposed on the first insulating layer and including a second voltage applying region which supplies the common voltage to the display region,
wherein the first insulating layer and the second insulating layer include a first contact hole which exposes the first voltage applying region, and the second insulating layer further includes a second contact hole which exposes the second voltage applying region.

13. The display device according to claim 12, wherein the first-sub supplying unit and the second sub-supplying unit are disposed as separate units which partially overlap, but do not directly contact each other.

14. The display device according to claim 13, further comprising a contact member which covers the first and second voltage applying regions and includes a transparent conductive material.

15. The display device according to claim 14, wherein the first sub-supplying unit comprises a first pad disposed in the non-display region, and the second sub-supplying unit comprises a second pad adjacent to the first pad, and
the first pad and the second pad are connected to the same power supplying unit.

16. The display device according to claim 12, wherein the first voltage applying region and the second voltage applying region are alternately and repetitively disposed along a first side of the common voltage supplying unit,
wherein the first side is disposed opposite the display region.

17. A display device comprising:
a substrate including a display region; and
a reference voltage supplying unit disposed along at least one side of the display region which supplies a reference voltage to the display region,
wherein the reference voltage supplying unit comprises at least two metal layers which are separated from each other.

18. A method of fabricating a display device, comprising:
disposing a first sub-supplying unit including a first pad and a first voltage supplying region;
disposing a first insulating layer on the first sub-supplying unit;
disposing a second sub-supplying unit including a second pad and a second voltage supplying region on the first insulating layer;
disposing a second insulating layer on the second sub-supplying unit;
forming a first contact hole on a first voltage supplying region and a second contact hole on a second voltage supplying region; and
electrically connecting a common electrode to the first voltage supplying region and the second voltage supplying region through the first contact hole and the second contact hole.

19. The method according to claim 18, wherein the first sub-supplying unit and the second sub-supplying unit are disposed adjacent to each other.

20. The method according to claim 19, wherein the first voltage supplying region and the second voltage supplying region are alternately and repetitively disposed along the length of the first and second sub-supplying units.

21. The method according to claim 18, further comprising supplying a voltage to the first and second sub-supplying units through the first and second pads.

22. The method according to claim 18, wherein the disposing a first sub-supplying unit comprises depositing and patterning a first metal layer on an insulating substrate, the disposing a second sub-supplying unit comprises depositing and patterning a second metal layer on the first insulating layer, and the forming a first contact hole comprises patterning the first insulating layer and the second insulating layer at substantially the same time.
